# EUROPEAN PATENT APPLICATION

(11) **EP 4 283 865 A1**
(43) Date of publication of application: **29.11.2023**
(21) Application number: 22203905.9
(22) Date of filing: 26.10.2022
(51) Int. Cl.: H03D 7/16, G01R 23/16, H03K 5/00

(54) **HIGH FREQUENCY SIGNAL ROCESSING DEVICE, MEASUREMENT EQUIPMENT, MEASUREMENT SYSTEM**

(30) Priority: 27.05.2022 EP 22175719
(71) Applicant: Rohde & Schwarz GmbH & Co. KG, 81671 München (DE)
(72) Inventor: HAMMERL, Christoph, 81549 München (DE); KROGLER, Robert, 83539 Pfaffing (DE); ADAM, Alois, 94265 Patersdorf (DE); THOENER, Alexander, 94234 Viechtach (DE)
(74) Representative: Kehl, Ascherl, Liebhoff & Ettmayr Patentanwälte Partnerschaft mbB

(57) **Abstract**

The present disclosure provides a high frequency signal processing device comprising an RF signal path with a respective RF coupling, a digital data storage configured to store device data referring to the high frequency signal processing device, and a digital interface coupled to the digital data storage and configured to couple the high frequency signal processing device with an external communication partner. Further, the present disclosure provides a respective measurement equipment, and a respective measurement system.

## Description

### TECHNICAL FIELD

The disclosure relates to a high frequency signal processing device, a measurement equipment, and a respective measurement system.

### BACKGROUND

Although applicable to any high frequency measurement device, the present disclosure will mainly be described in conjunction with external addon devices for high frequency measurement equipment.

In modern measurement applications, signals with very high frequencies need to be generated and measured. In such measurement applications, external devices may be coupled to a measurement device or other measurement equipment to perform respective signal processing, usually in the analog domain.

There is a need for managing a high number of such external devices.

### SUMMARY

The above stated problem is solved by the features of the independent claims. It is understood, that independent claims of a claim category may be formed in analogy to the dependent claims of another claim category.

Accordingly, it is provided:
A high frequency signal processing device comprising an RF signal path with a respective RF coupling, a digital data storage configured to store device data referring to the high frequency signal processing device, and a digital interface coupled to the digital data storage and configured to couple the high frequency signal processing device with an external communication partner.

Further, it is provided:
A measurement equipment comprising a RF coupling configured to couple to the RF coupling of a high frequency signal processing device according to the present disclosure, and a digital device interface configured to couple to the digital interface of the high frequency signal processing device and to exchange device data with the high frequency signal processing device.

Further, it is provided:
A measurement system comprising at least one high frequency signal processing device according to the present disclosure, and at least one measurement equipment according to the present disclosure, wherein the RC coupling of the at least one high frequency signal processing device is coupled to the RF coupling of one of the at least one measurement equipment, and wherein the digital interface of the at least one high frequency signal processing device is coupled to the digital device interface of one of the at least one measurement equipment.

The present disclosure is based on the finding that in modern high frequency measurement applications a plurality of external or addon devices may be used with a respective measurement equipment.

An exemplary measurement equipment may for example be a frequency converter. Such frequency converters may be used in measurement applications in combination with other equipment, like for example vector network analyzers.

In an exemplary measurement application, a vector network analyzer may be used with two frequency converters to perform a 2-port transmission measurement. The frequency converters may use frequency multipliers to transform the RF source signal from one of the network analyzer ports into a high-frequency stimulus signal. A second signal may be used for down-conversion of the reference and measurement channels. The second signal can be provided either by a second analyzer port or by an external generator. With modern millimeter wave converters, measurements of up to 1.0 THz and more are easily possible.

When performing measurements with such millimeter wave converters, addon devices may be used to process the signals provided from the millimeter wave converters or to the millimeter wave converters. Such addon devices may comprise filters, attenuators, amplifiers, mixers and the like. The devices are provided as separate addon devices, since in respective frequency ranges of up to or more than 1.0 THz, there exist no switches to include multiple switchable addon devices into the respective measurement equipment.

Addon devices exist in a huge variety and different variants are available for specific measurement tasks and frequency ranges. When using such an addon device in a measurement application, the measurement device needs to be configured manually to use the respective addon device.

Of course, when a huge variety of addon devices exists, manual configuration of the measurement device for a respective high frequency signal processing device is a cumbersome and error prone task.

The present invention, therefore, provides the high frequency signal processing device as addon device together with a respective measurement equipment that may be used together in a measurement application. The measurement equipment may for example, comprise millimeter wave frequency converters, vector network analyzers and the like. The high frequency signal processing device and the measurement equipment together may form a measurement system according to the present disclosure.

It is understood, that in the context of the present disclosure, the term "measurement equipment" may refer to a single device or to multiple devices that are connected or coupled to each other. A measurement equipment may for example refer to a millimeter wave frequency converter, or to a vector network analyzer, or to a spectrum analyzer, or to a frequency converter, or to the combination of at least two of a millimeter wave frequency converter, a vector network analyzer, a spectrum analyzer, and a frequency converter.

The high frequency signal processing device as addon device is specifically designed to overcome the variant management troubles of former addon devices. To this end, the high frequency signal processing device provides the digital data storage and the digital interface in addition to the RF signal path.

The RF signal path serves to perform any signal processing or modification of the RF signal that is to be processed by the high frequency signal processing device.

The digital data storage, in contrast, stores device data referring to the high frequency signal processing device, especially to the RF signal path. This device data may be read via the digital interface by a respective measurement equipment according to the present disclosure like for example, a millimeter wave converter or a vector network analyzer.

The measurement equipment may then use the device data to perform an internal configuration that allows the measurement equipment to correctly operate with the high frequency signal processing device.

It is understood, that the digital data storage, and if present any other element, unit, or device in the digital section, may in embodiments be supplied with electrical energy via the digital interface. Such electrical energy may for example be provided by the measurement equipment that is coupled to the high frequency signal processing device via the digital interface.

In addition, the digital interface may comprise any adequate hardware coupling or connector that may be adequate for coupling the high frequency signal processing device to a measurement equipment. Such a hardware coupling may for example comprise connectors like used for example, in computers or industrial applications. An exemplary connector may be a connector according to the standard IEC 61076-3-124, or a RJ45 connector.

It is understood, that the digital data storage may be interfaced directly to a respective measurement equipment via the digital interface. In such an embodiment, a communication method provided by the digital data storage may be used. For example, the digital data storage may support data communication according to the SPI standard or the I²C standard.

In other embodiments, the digital data storage may be coupled to a communication controller that performs data communication via the digital interface. The communication controller may for example implement wired communication standards like at least one of the Ethernet communication standard and the USB communication standard, or wireless communication standards like at least one of the Bluetooth communication standard, the WIFI communication standard, the RFID communication standard, and the NFC communication standard.

Of course, the digital interface may also be provided as an optical communication interface that communicates wired or wirelessly via visible or non-visible light. A respective communication controller may be provided in such embodiments

In embodiments, the digital data storage unit may comprise the respective communication controller.

With the high frequency signal processing device and the measurement equipment according to the present disclosure, no manual configuration of the measurement equipment regarding the high frequency signal processing device is required. The measurement equipment may, instead, perform a kind of self-configuration based on the device data.

Manually misconfiguring the measurement equipment for a respective high frequency signal processing device is therefore effectively prevented.

Further embodiments of the present disclosure are subject of the further dependent claims and of the following description, referring to the drawings.

In an embodiment, the RF signal path may comprise an RF function block coupled to the RF coupling.

The RF function block may comprise for example, at least one of a filter device, an attenuation device, an amplifier device, and a mixer device. Such an RF function block may be arranged between an RF input connection and an RF output connection of the RF coupling.

In embodiments, the RF function block may comprise at least one resonance chamber, where the exact configuration and shape of the at least one resonance chamber determines a filter characteristic of the RF function block.

In a further embodiment, the RF signal path may comprise a waveguide signal path.

In cases, where the RF signal path is provided as waveguide signal path, no active semiconductor circuit components, or analog circuit components, like resistors, inductors, and capacitors are provided in the RF signal path. Instead, such a waveguide signal path will provide the required properties based on the geometry of a cavity or multiple cavities provided in a block of conductive material. Such waveguide signal paths may especially serve to conduct signals at very high frequencies and also at high power levels.

In another embodiment, the RF coupling may comprise at least one waveguide connector.

The waveguide connector may be provided for example, as a flange or a respective coupling terminal or section of a metallic structure that incorporates or implements the RF signal path.

It is understood, that in other embodiments, the RF signal path may be a conductor-based signal path. In embodiments, at least the RF coupling may comprise RF connectors like, coaxial connectors, as input and output.

In embodiments, the RF coupling may comprise an antenna or antenna connector as one means to couple in an RF signal into the RF signal path or to couple out an RF signal out of the RF signal path.

In yet another embodiment, the high frequency signal processing device may comprise a shielded housing configured to accommodate the RF signal path with the RF coupling and the digital data storage with the digital interface. The shielded housing may be configured to electromagnetically shield the RF signal path with the RF coupling from the digital data storage with the digital interface.

In measurement applications signal integrity is vital to provide valid measurement results. Consequently, in the high frequency signal processing device the RF signal section i.e., the RF signal path with the RF coupling, is to be separated electromagnetically from the digital section i.e., the digital data storage and the digital interface.

To this end, the shielded housing is provided that accommodates the RF signal path with the RF coupling and the digital data storage with the digital interface, such that the RF signal section is shielded from the digital section and vice versa.

In another embodiment, the shielded housing may comprise a first housing section and a second housing section that is detachably coupled to the first housing section. The first housing section may accommodate the RF signal path with the RF coupling, and the second housing section may accommodate the digital data storage and the digital interface.

Providing the first housing section and the second housing section allows adapting each of the housing sections specifically to the respective elements that the housing section should accommodate.

In an example where the RF signal path and the RF coupling comprise waveguides and waveguide couplings, the RF signal path and the RF coupling may be formed directly in the material of the first housing section. The first housing section may for example comprise two half shells that are fixed to each other, wherein the RF signal path may be formed by milling a cavity of the required shape into the half shells.

Since the second housing section does not need to provide any function regarding signal conduction or signal modification, the second housing section may simply comprise a respective cavity to accommodate for example, a circuit board that carries the digital data storage and the hardware of the digital interface.

With the two housing sections, it is easily possible to exchange for example, only the second housing section to accommodate a different digital data interface.

The first housing section and the second housing section may for example be coupled to each other by screws, clips, clamps, or by gluing or soldering.

In a further embodiment, the device data stored in the digital data storage may comprise a unique identifier for the high frequency signal processing device.

A unique identifier is unique for every high frequency signal processing device. Any measurement equipment that is coupled to the high frequency signal processing device may, therefore, use the unique identifier to determine which high frequency signal processing device it is coupled to.

After determining the exact high frequency signal processing device, the measurement equipment may then look up any further data that is required by the measurement equipment to operate with the high frequency signal processing device and configure itself accordingly.

The data may comprise parameters that characterize the RF signal path. Such parameters may characterize for example, at least one of a transmission loss of the RF signal path, a phase response of the RF signal path, a temperature compensation data for the RF signal path, and a noise figure of the RF signal path, and correction data for correcting signal distortions that may be caused by the RF signal path in the measurement equipment.

The measurement equipment may comprise a local data storage that comprises the required data for all possible high frequency signal processing devices. Of course, such a local data storage may grow huge with increasing number of high frequency signal processing devices.

Therefore, in addition or as alternative to a local data storage, the measurement equipment may also retrieve the required data from at least one of a local network server, an internet server, and a cloud service. Of course, such servers or services may provide any kind of adequate interface, like for example direct database access, or an API-based access like for example, a REST API, a SOAP API or a CORBA API.

It is understood, that the measurement equipment according to the present invention may incorporate any adequate communication capability to retrieve the required data.

The measurement equipment may in embodiments communicate directly with the respective source of the required data i.e., the local server, the internet server or the cloud service. In embodiments, the measurement equipment may also communicate indirectly with the source of the required data. Indirectly in this regard refers to the measurement equipment communicating for example via a VPN gateway, a proxy, or a dedicated host with data exchange capabilities, also called jump host, that may be provided with the measurement equipment in the same network.

Of course, such a server or cloud service may also provide the user with a respective interface like for example, a web interface. The server or cloud service may for example allow the user to review which measurement equipment is coupled to which high frequency signal processing device, or which settings or configurations are applied in a respective measurement equipment based on the data regarding the high frequency signal processing device provided by the server or cloud service.

In embodiments, the digital data storage may also perform authentication or identification tasks, like for example a smartcard or chipcard. In such embodiments, the measurement equipment may communicate respective authentication data from the respective server or service to the digital data storage. The digital data storage may perform the required authentication steps. The authentication may for example be performed similar to a PC with a smartcard reader authenticating to a website.

In yet another embodiment, the device data stored in the digital data storage may comprise data characterizing at least one of the RF signal path and the RF coupling.

As explained above, the measurement equipment may retrieve the data regarding the high frequency signal processing device that is required for configuring the measurement equipment from a server or cloud service.

As alternative to storing such data remotely, the data may also be stored directly within the digital data storage. In such cases the measurement equipment may retrieve the data that characterizes the RF signal path and/or the RF coupling from the digital data storage via the digital interface, and perform respective internal settings or configuration based on the retrieved data.

With the data that characterizes at least one of the RF signal path and the RF coupling stored in the digital data storage, the measurement equipment may receive this data even without an online connection.

In embodiments, the data that characterizes at least one of the RF signal path and the RF coupling may be stored in the digital data storage and may be requested by the measurement equipment from a server or cloud service. The locally stored data may then serve as a backup if the server or cloud service is not reachable. The measurement equipment may also store the data locally or in the digital data storage after retrieving it from the server or cloud service.

In embodiments, the measurement equipment may perform regular measurements of specific characteristics of the high frequency signal processing device and provide the measurement results to the server or cloud server. The server or cloud server may then, based on the measurement results, determine if the high frequency signal processing device may need a service or if the data that characterizes at least one of the RF signal path and the RF coupling should be re-determined. If this is the case, a respective indication may be provided to the user of the measurement equipment, for example via a user interface of the measurement equipment.

In another embodiment, the digital data storage may be configured to receive updated device data via the digital interface and to store the updated device data.

In embodiments, the RF characteristics of the high frequency signal processing device may change or drift over time. In order to compensate for such changes or drifts, the device data in the digital data storage may be updated when required.

The measurement equipment may for example be used in or be put into a calibration mode that serves to determine the characteristics of the high frequency signal processing device.

The calibration mode may include setting up a specific calibration measurement arrangement that couples the measurement equipment with the high frequency signal processing device such that the characteristics of the high frequency signal processing device may be determined reliably. It is understood, that in the calibration mode, the high frequency signal processing device may be coupled differently to the measurement equipment or to another type of measurement equipment than in a normal operation mode, where the high frequency signal processing device is used in the signal chain of the signal to be measured.

After determining the characteristics of the high frequency signal processing device, the measurement equipment may store respective data locally or in the digital data storage or may provide the data to the server or cloud service.

In a further embodiment, the digital interface may be configured to receive control data for controlling at least one configurable element of the RF signal path.

The RF signal path may comprise configurable elements like for example, configurable filters, configurable attenuators, and configurable amplifiers. Of course, the high frequency signal processing device may comprise means for a user to configure such elements. The high frequency signal processing device may for example comprise a display and buttons or a touchscreen. However, when coupled with a measurement equipment, the measurement equipment may also provide respective control data to the high frequency signal processing device. Of course, a user may set the control data via a user interface of the measurement equipment.

In yet another embodiment, the digital interface may be configured to output measurement data measured by at least one measurement element of the RF signal path.

The high frequency signal processing device may also comprise measurement elements like for example, analog-to-digital converters (ADCs), that may measure signals in the RF signal path. In such embodiments, the digital interface may also output measurement data from such devices or elements.

In another embodiment, the measurement equipment may further comprise a communication interface configured to retrieve data that characterizes at least one of the RF signal path and the RF coupling of the high frequency signal processing device from an external source based on the device data.

In a further embodiment, the measurement equipment may further comprise an electrical power supply coupled to the digital device interface and configured to supply electrical power to the high frequency signal processing device via the digital device interface.

The electrical power supply of the measurement equipment may of course serve as the main power supply of the measurement equipment, and may in addition supply the high frequency signal processing device with electrical power.

In embodiments, the measurement equipment may be coupled to an external electrical power supply. In such embodiments, the internal electrical power supply of the measurement equipment may comprise circuitry or elements required to forward electrical power to the high frequency signal processing device from the external electrical power supply.

In an embodiment of the measurement system the high frequency signal processing device comprises an RF filter in the RF signal path, and the measurement equipment comprises a millimeter wave converter.

In another embodiment, the measurement system may further comprise a server or cloud service configured to provide data that characterizes at least one of the RF signal path and the RF coupling of the high frequency signal processing device to the measurement equipment.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a schematic diagram of an embodiment of a high frequency signal processing device according to the present disclosure;
Figure 2 shows a schematic diagram of an embodiment of two half shells forming a shielded housing according to the present disclosure;
Figure 3 shows a schematic diagram of another embodiment of a high frequency signal processing device according to the present disclosure;
Figure 4 shows a schematic diagram of an embodiment of a measurement equipment according to the present disclosure;
Figure 5 shows a schematic diagram of an embodiment of a measurement system according to the present disclosure;
Figure 6 shows a schematic diagram of another embodiment of a high frequency signal processing device according to the present disclosure; and
Figure 7 shows a schematic diagram of an embodiment of a high frequency signal processing device according to the present disclosure.

In the figures like reference signs denote like elements unless stated otherwise.

### DETAILED DESCRIPTION OF THE DRAWINGS

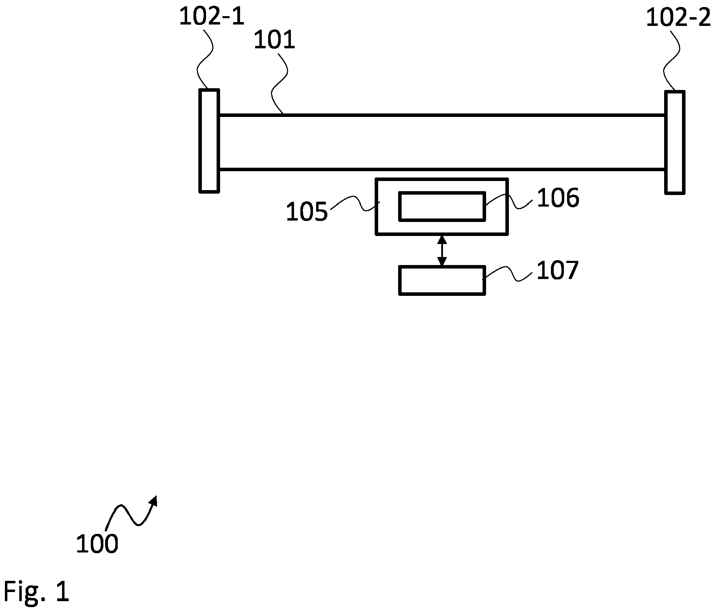

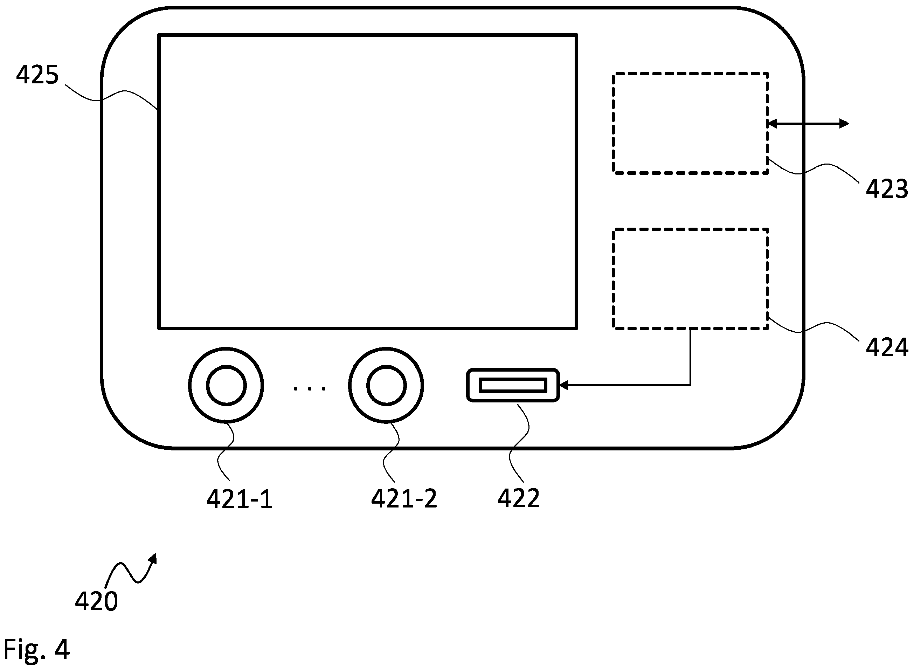

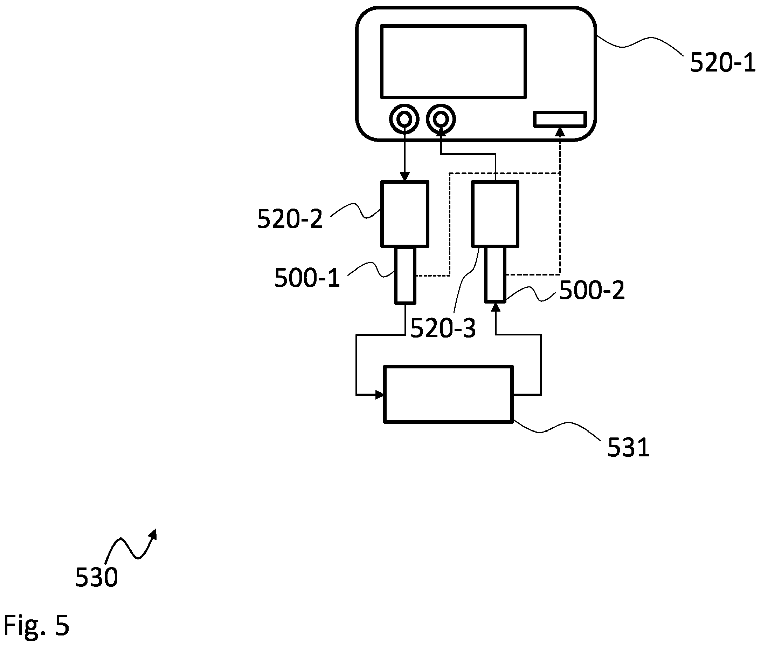

Figure 1 shows a schematic diagram of a high frequency signal processing device 100. The high frequency signal processing device 100 comprises an RF signal path 101 with a respective RF coupling, implemented as RF input 102-1 and RF-output 102-2. The high frequency signal processing device 100 further comprises a digital data storage 105 that stores device data 106. The device data 106 comprises information about the high frequency signal processing device 100, especially about the RF characteristics of the high frequency signal processing device 100. In addition, the high frequency signal processing device 100 comprises a digital interface 107 that is coupled to the digital data storage 105 and that is designed to couple the high frequency signal processing device 100 with an external communication partner, for example a measurement equipment as shown in Figures 4 or 5.

The RF signal path 101 is provided as a waveguide signal path 101 with two flanges as RF input 102-1 and RF-output 102-2. It is understood, that the RF signal path 101 may implement any required function like for example, a filter, an attenuator, an amplifier, or a mixer.

The device data 106 stored in the digital data storage 105 may for example comprise a unique identifier for the high frequency signal processing device 100. With the unique identifier the measurement equipment may retrieve any data required to operate with the high frequency signal processing device 100, for example from a server or cloud service.

In addition, or as alternative, the device data 106 may comprise data characterizing at least one of the RF signal path 101 and the RF coupling 102-1, 102-2. The measurement equipment may use this data to configure itself internally, without the need to retrieve any data from another source. The digital data storage 105 may also receive updated device data 106 via the digital interface 107and to store the updated device data 106, if such data is retrieved e.g. from a server or cloud service by the measurement equipment.

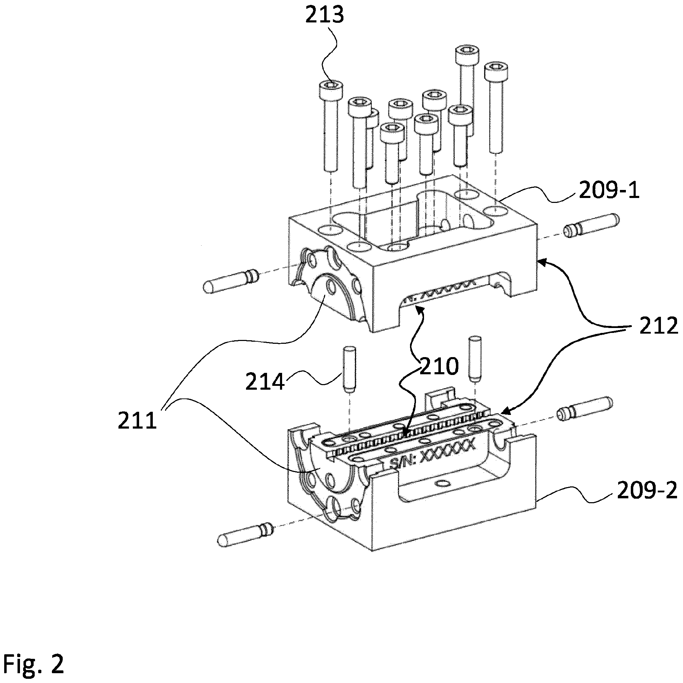

Figure 2 shows a schematic diagram of an upper half shell 209-1 and a lower half shell 209-2, which together form the first section of a shielded housing according to the present disclosure.

The upper half shell 209-1 and the lower half shell 209-2 may both be fixed to each other via respective screws 213 and pins 214. For sake of clarity only one screw and one pin are provided with a reference sign. It is understood, that the number of screws and pins as shown in Figure 2 is only exemplarily chosen, and that any other number of screws and pins may be used to couple an upper half shell 209-1 and a lower half shell 209-2 to each other.

Both, the upper half shell 209-1 and the lower half shell 209-2, comprise an essentially square-block like shape. On opposing ends, the upper half shell 209-1 and the lower half shell 209-2 each provide half of a first RF connector 211 and a second RF connector 212, which may also be provided with pins to allow exactly positioning the respective counterpart.

Between the sections of the upper half shell 209-1 and the lower half shell 209-2 that form the first RF connector 211 and the second RF connector 212, the upper half shell 209-1 and the lower half shell 209-2 each comprise an RF function block 210. In the example of Figure 2, the RF function block 210 comprises a respectively formed resonance chamber that provides a filter effect for an RF signal.

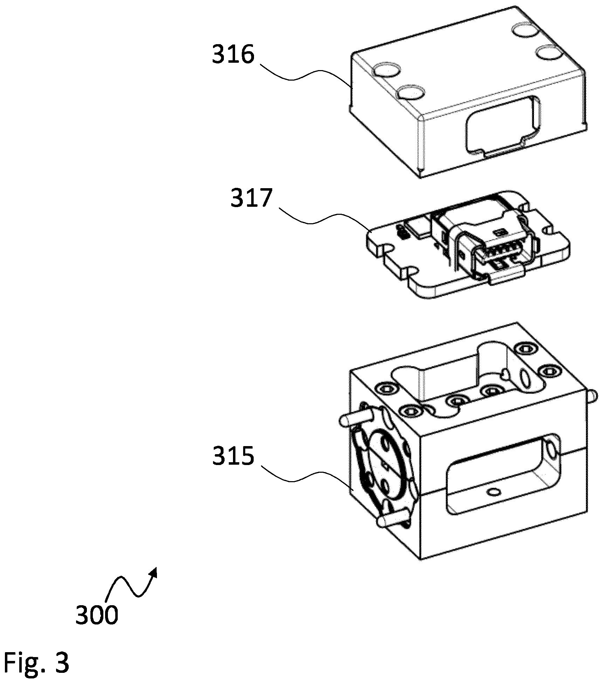

Figure 3 shows a schematic diagram of a high frequency signal processing device 300. The high frequency signal processing device 300 comprises the first housing section 315 as shown in an opened state in Figure 2. In addition, the high frequency signal processing device 300 comprises a second housing section 316 and a printed circuit board 317.

The second housing section 316 is formed such, that it accommodates the printed circuit board 317 and that it may be coupled to the first housing section 315 e.g., via screws.

In order to provide a shielding effect, the first housing section 315 and the second housing section 316 may for example be provided from conductive material, like a metal material.

Although not shown in more detail, it is understood, that the printed circuit board 317 carries the digital data storage and the digital interface. Further, any required additional circuitry, like for example power supply circuitry, may be provided on the printed circuit board 317. The connector for the digital interface is provided as an IEC 61076-3-124 connector. It is understood, that any other adequate connector may also be used.

Figure 4 shows a schematic diagram of a measurement equipment 420 that may be used with a high frequency signal processing device according to the present disclosure. The measurement equipment 420 comprises two RF couplings 421-1, 421-2 or RF channels, and a digital device interface 422. As optional elements, the measurement equipment 420 may comprise a communication interface 423 and an electrical power supply 424. The measurement equipment 420 further comprises a display or user interface 425. The measurement equipment 420 may for example be a vector network analyzer. In other embodiments, the measurement equipment may have no display or user interface. Such measurement equipment may for example be a millimeter wave converter.

Although two RF couplings 421-1, 421-2 are shown, it is understood, that the measurement equipment 420 may comprise more or less RF couplings. The RF couplings 421-1, 421-2 may be provided as waveguide couplings. In other embodiments, the RF couplings 421-1, 421-2 may be provided as coaxial couplings.

In a measurement application, at least one of the RF couplings 421-1, 421-2 may be coupled to the respective RF coupling of high frequency signal processing device according to the present disclosure.

The digital device interface 422 may couple to the digital interface of the same high frequency signal processing device and may exchange device data with the high frequency signal processing device.

Although not explicitly shown, it is understood, that the measurement equipment 420 may comprise a controller or processor that executes a computer program product or computer readable instructions that when executed together with the hardware of the measurement equipment 420 provide the function of the measurement equipment 420. Such a controller or processor may use the received device data to perform internal configurations of the measurement equipment 420, that allow the measurement equipment 420 to operate correctly with the respective high frequency signal processing device like for example, configuring a predistortion of baseband signals or adjusting the RF power.

The optional communication interface 423 may be used to retrieve data that characterizes at least one of the RF signal path and the RF coupling of a respective high frequency signal processing device from an external source based on the device data. The communication interface 423 may for example be used, if the device data does not comprise the data that characterizes at least one of the RF signal path and the RF coupling, but only an ID of the respective high frequency signal processing device. Of course, the controller or processor of the measurement equipment 420 may be coupled to the communication interface 423 and retrieve the respective data.

The electrical power supply 424 may be the main power supply of the measurement equipment 420 and may in addition be coupled to the digital device interface 422 to supply electrical power to the high frequency signal processing device via the digital device interface.

Figure 5 shows a schematic diagram of an embodiment of a measurement system 530. The measurement system 530 is an exemplary arrangement that shows how the elements of the present disclosure may be used in conjunction.

The measurement system 530 comprises three measurement equipment devices, a vector network analyzer 520-1, a first millimeter wave converter 520-2, and a second millimeter wave converter 520-3.

The vector network analyzer 520-1 is coupled via a first RF coupling to the first millimeter wave converter 520-2. The first millimeter wave converter 520-2 is coupled to a high frequency signal processing device 500-1, and the high frequency signal processing device 500-1 is coupled to an input of a device under test 531, DUT. The output of the DUT 531 is coupled to an input of a second high frequency signal processing device 500-2. The second high frequency signal processing device 500-2 is coupled to the second millimeter wave converter 520-3, that is coupled to another RF coupling of the vector network analyzer 520-1.

The first high frequency signal processing device 500-1 and the second high frequency signal processing device 500-2 may for example provide at least one of filtering functions, attenuation functions, mixing functions, and amplification functions. Of course, in other embodiments, the measurement system 530 may only have the vector network analyzer 520-1 or only the vector network analyzer 520-1 with one of the first millimeter wave converter 520-2 and the second millimeter wave converter 520-3. In further embodiments, instead of the single vector network analyzer 520-1, the first and second high frequency signal processing device 500-1, 500-2 may be coupled to different measurement equipment devices, like for example a signal generator and a spectrum analyzer. Further, a single high frequency signal processing device or more than two high frequency signal processing devices may be used.

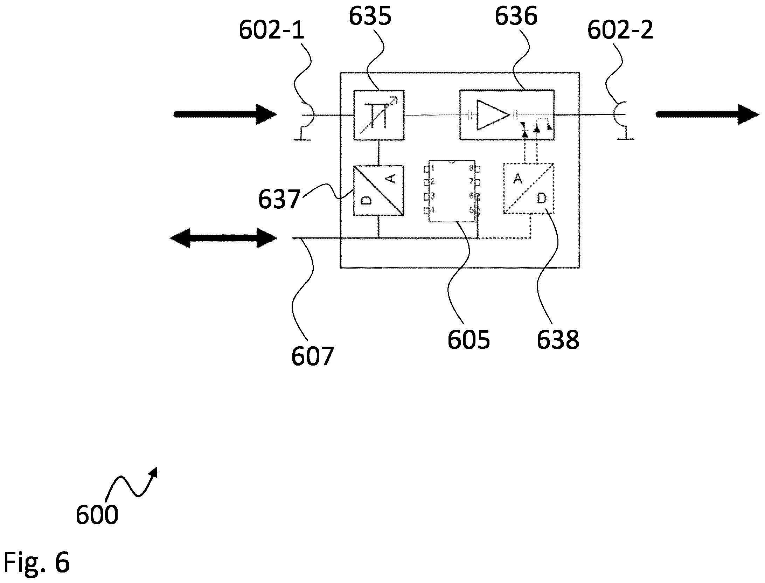

Figure 6 shows a schematic diagram of embodiment of a high frequency signal processing device 600. The high frequency signal processing device 600 comprises a RF coupling with an RF input 602-1 and an RF-output 602-2. Between the RF input 602-1 and the RF-output 602-2 a variable attenuator 635 and an amplifier 636 are provided.

In addition, the high frequency signal processing device 600 comprises a digital interface 607 that is coupled with a digital data storage 605, and with a digital-to-analog converter 637, and an optional analog-to-digital converter 638.

The digital-to-analog converter 637 may be provided with respective digital data via the digital interface 607 and may provide a respective analog voltage value to the variable attenuator 635. The variable attenuator 635 may, therefore, be controlled via the digital interface 607.

The optional analog-to-digital converter 638 is coupled with the amplifier 636 and may read a voltage level from the amplifier 636. This voltage level may then be converted to a digital value and may be output via the digital interface 607.

The voltage level may for example be characterizing for a power level of the amplified signal after passing the amplifier 636. The information about this power level may be used in a respective measurement equipment for example, to adjust an output power.

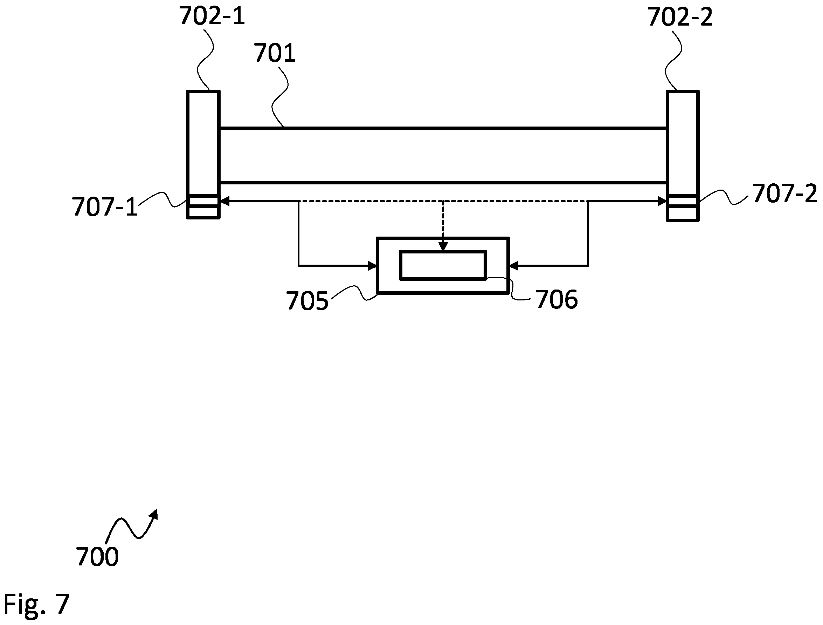

Figure 7 shows a further schematic diagram of a high frequency signal processing device 700 that is based on the high frequency signal processing device 100. The high frequency signal processing device 700, consequently, comprises an RF signal path 701 with a respective RF coupling, implemented as RF input 702-1 and RF-output 702-2. The high frequency signal processing device 700 further comprises a digital data storage 705 that stores device data 706. The explanations provided above regarding the high frequency signal processing device 100 apply to the high frequency signal processing device 700 mutatis mutandis where adequate. In addition, the high frequency signal processing device 700 may be combined with the features of any of the other embodiments of the high frequency signal processing device as disclosed herein.

In addition, the high frequency signal processing device 700 comprises a two-part digital interface 707-1, 702 that is integrated into the RF coupling. The first part 707-1 of the digital interface is integrated into the RF input 702-1, and the second part 707-2 of the digital interface is integrated into the RF-output 702-2.

In exemplary embodiments, the RF input 702-1 and the RF-output 702-2 may be provided with a flange, and the first part 707-1, and the second part 707-2 of the digital interface may be provided as at least one of contacts, contact pins, contact springs, or any other adequate type of electrical or optical coupling on the front sides of the flanged of RF input 702-1, and RF-output 702-2.

The first part 707-1, and the second part 707-2 are both coupled to the digital data storage 705 and may each couple the high frequency signal processing device 700 with an external communication partner, for example a measurement equipment as shown in Figures 4 or 5 or another high frequency signal processing device 700. The coupling of the first part 707-1, and the second part 707-2 are both coupled to the digital data storage 705 separately (indicated by solid lines). In such an embodiment, the digital data storage 705 may serve as a hub or gateway for forwarding data between the first part 707-1, and the second part 707-2.

In other embodiments (indicated by dashed lines), the first part 707-1, and the second part 707-2 may be coupled to each other, and the digital data storage 705 may be coupled to the connection between the first part 707-1, and the second part 707-2.

It is understood, that not only one first part 707-1, and one second part 707-2 may be provided. In embodiments, one part may be provided for each pin or signal line of the digital data connection on each one of the RF input 702-1, and the RF-output 702-2. With such multi-pin or multi-line arrangements, the single signal lines may carry supply voltages, digital signals, or analog signals, as required by the respective application.

With the arrangement, as shown in the high frequency signal processing device 700, it is now possible to couple multiple high frequency signal processing devices 700 to each other in a line or chain like arrangement, and perform digital data communication with all the coupled high frequency signal processing devices 700. To this end, any adequate digital data bus system or protocol may be used. Possible bus systems or protocols include, but are not limited to, an 12C bus, an SPI bus, a USB bus, a UART-based serial bus, a parallel data bus.

In embodiments with multiple first and second parts i.e., multiple communication lines or pins, the first parts 707-1 may be arranged symmetrically to a center axis of the RF input 702-1, when viewed in a front view (from the left in figure 7). In addition, the second parts 707-2 may be arranged symmetrically to a center axis of the RF output 702-2, when viewed in a front view (from the right in figure 7). This allows mounting the high frequency signal processing device 700 at least in a 0° angle and a 180° angle, with the first and second parts of two high frequency signal processing device 700 still coupling to each other. The same applies to any measurement equipment that may be coupled with a high frequency signal processing device 700.

With multiple first parts and second parts, the digital data storage 705 may comprise a detector that detects which one of the signal lines or first and second parts carries that type of signal. In case, that multiple high frequency signal processing devices 700 are coupled to each other with a 180° rotation between each other, the digital data storage 705 may then identify the signals on the different lines and use them accordingly. For example, a clock and a data line may be switched, or a supply line and a data line may be switched. With the detector, the digital data storage 705 may adapt to this situation. Alternatively, all required first and second parts may be provided at least twice i.e., with a 0° and a 180° orientation.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

### LIST OF REFERENCE SIGNS

- 100, 300, 500-1, 500-2, 600, 700: high frequency signal processing device
- 101, 701: RF signal path
- 102-1, 102-2, 602-1, 602-2, 702-1, 702-2: RF coupling
- 105, 605, 705: digital data storage
- 106, 706: device data
- 107, 607, 707-1, 707-2: digital interface

- 209-1, 209-2: half shell
- 210, 310: RF function block
- 211, 311: first RF connector
- 212, 312: second RF connector
- 213: screw
- 214: pin

- 315: first housing section
- 316: second housing section
- 317: printed circuit board

- 420, 520-1, 520-2, 520-3: measurement equipment
- 421-1, 421-2: RF coupling
- 422: digital device interface
- 423: communication interface
- 424: electrical power supply
- 425: display

- 530: measurement system
- 531: DUT

- 635: variable attenuator
- 636: amplifier
- 637: digital-to-analog converter
- 638: analog-to-digital converter

## Claims

1. High frequency signal processing device (100, 300, 500-1, 500-2, 600, 700) comprising:
an RF signal path (101, 701) with a respective RF coupling (102-1, 102-2, 602-1, 602-2, 702-1, 702-2);
a digital data storage (105, 605, 705) configured to store device data (106, 706) referring to the high frequency signal processing device (100, 300, 500-1, 500-2, 600, 700); and
a digital interface (107, 607, 707-1, 707-2) coupled to the digital data storage (105, 605, 705) and configured to couple the high frequency signal processing device (100, 300, 500-1, 500-2, 600, 700) with an external communication partner.

2. High frequency signal processing device (100, 300, 500-1, 500-2, 600, 700) according to claim 1, wherein the RF signal path (101, 701) comprises an RF function block (210, 310) coupled to the RF coupling (102-1, 102-2, 602-1, 602-2, 702-1, 702-2).

3. High frequency signal processing device (100, 300, 500-1, 500-2, 600, 700) according to any of the preceding claims,
wherein the RF signal path (101, 701) comprises a waveguide signal path; and/or
wherein the RF coupling (102-1, 102-2, 602-1, 602-2, 702-1, 702-2) comprises at least one waveguide connector.

4. High frequency signal processing device (100, 300, 500-1, 500-2, 600, 700) according to any of the preceding claims, comprising a shielded housing configured to accommodate the RF signal path (101, 701) with the RF coupling (102-1, 102-2, 602-1, 602-2, 702-1, 702-2) and the digital data storage (105, 605, 705) with the digital interface (107, 607, 707-1, 707-2), wherein the shielded housing is configured to electromagnetically shield the RF signal path (101, 701) with the RF coupling (102-1, 102-2, 602-1, 602-2, 702-1, 702-2) from the digital data storage (105, 605, 705) with the digital interface (107, 607, 707-1, 707-2).

5. High frequency signal processing device (100, 300, 500-1, 500-2, 600, 700) according to claim 4, wherein the shielded housing comprises a first housing section (315) and a second housing section (316) that is detachably coupled to the first housing section (315), wherein the first housing section (315) accommodates the RF signal path (101, 701) with the RF coupling (102-1, 102-2, 602-1, 602-2, 702-1, 702-2), and wherein the second housing section (316) accommodates the digital data storage (105, 605, 705) and the digital interface (107, 607, 707-1, 707-2).

6. High frequency signal processing device (100, 300, 500-1, 500-2, 600, 700) according to any of the preceding claims, wherein the device data (106, 706) stored in the digital data storage (105, 605, 705) comprises a unique identifier for the high frequency signal processing device (100, 300, 500-1, 500-2, 600, 700).

7. High frequency signal processing device (100, 300, 500-1, 500-2, 600, 700) according to any of the preceding claims, wherein the device data (106, 706) stored in the digital data storage (105, 605, 705) comprises data characterizing at least one of the RF signal path (101, 701) and the RF coupling (102-1, 102-2, 602-1, 602-2, 702-1, 702-2).

8. High frequency signal processing device (100, 300, 500-1, 500-2, 600, 700) according to anyone of the preceding claims, wherein the digital data storage (105, 605, 705) is configured to receive updated device data (106, 706) via the digital interface (107, 607, 707-1, 707-2) and to store the updated device data (106, 706).

9. High frequency signal processing device (100, 300, 500-1, 500-2, 600, 700) according to any of the preceding claims,
wherein the digital interface (107, 607, 707-1, 707-2) is configured to receive control data for controlling at least one configurable element of the RF signal path (101, 701); and/or
wherein the digital interface (107, 607, 707-1, 707-2) is configured to output measurement data measured by at least one measurement element of the RF signal path (101, 701).

10. Measurement equipment (420, 520-1, 520-2, 520-3) comprising:
a RF coupling (421-1, 421-2) configured to couple to the RF coupling (102-1, 102-2, 602-1, 602-2, 702-1, 702-2) of a high frequency signal processing device (100, 300, 500-1, 500-2, 600, 700) according to anyone of the preceding claims;
a digital device interface (422) configured to couple to the digital interface (107, 607, 707-1, 707-2) of the high frequency signal processing device (100, 300, 500-1, 500-2, 600, 700) and to exchange device data (106, 706) with the high frequency signal processing device (100, 300, 500-1, 500-2, 600, 700).

11. Measurement equipment (420, 520-1, 520-2, 520-3) according to claim 10, further comprising a communication interface (423) configured to retrieve data that characterizes at least one of the RF signal path (101, 701) and the RF coupling (102-1, 102-2, 602-1, 602-2, 702-1, 702-2) of the high frequency signal processing device (100, 300, 500-1, 500-2, 600, 700) from an external source based on the device data (106, 706).

12. Measurement equipment (420, 520-1, 520-2, 520-3) according to any of the preceding claims 10 and 11, further comprising an electrical power supply (424) coupled to the digital device interface (422) and configured to supply electrical power to the high frequency signal processing device (100, 300, 500-1, 500-2, 600, 700) via the digital device interface (422).

13. Measurement system (530) comprising:
at least one high frequency signal processing device (100, 300, 500-1, 500-2, 600, 700) according to any of the preceding claims 1 to 9; and
a measurement equipment (420, 520-1, 520-2, 520-3) according to any of the preceding claims 10 to 12;
wherein the RC coupling of the at least one high frequency signal processing device (100, 300, 500-1, 500-2, 600, 700) is coupled to the RF coupling of the measurement equipment (420, 520-1, 520-2, 520-3); and
wherein the digital interface (107, 607, 707-1, 707-2) of the at least one high frequency signal processing device (100, 300, 500-1, 500-2, 600, 700) is coupled to the digital device interface (422) of the measurement equipment (420, 520-1, 520-2, 520-3).

14. Measurement system (530) according to claim 13, wherein the high frequency signal processing device (100, 300, 500-1, 500-2, 600, 700) comprises an RF filter in the RF signal path (101, 701); and
wherein the measurement equipment (420, 520-1, 520-2, 520-3) comprises a millimeter wave converter.

15. Measurement system (530) according to any of the preceding claims 13 and 14, further comprising a server or cloud service configured to provide data that characterizes at least one of the RF signal path (101, 701) and the RF coupling (102-1, 102-2, 602-1, 602-2, 702-1, 702-2) of the high frequency signal processing device (100, 300, 500-1, 500-2, 600, 700) to the measurement equipment (420, 520-1, 520-2, 520-3).
